# NEUE EUROPÄISCHE PATENTSCHRIFT

(11) **EP 2 494 339 B2**
(45) Veröffentlichungstag und Bekanntmachung des Hinweises auf die Entscheidung über den Einspruch: **24.03.2021**
(45) Hinweis auf die Patenterteilung: 19.07.2017
(21) Anmeldenummer: 10751799.7
(22) Anmeldetag: 13.08.2010
(51) Int. Cl.: G01N 21/95

(54) **VERFAHREN ZUR DETEKTION VON RISSEN IN HALBLEITERSUBSTRATEN**
METHOD FOR DETECTING CRACKS IN SEMICONDUCTOR SUBSTRATES
PROCÉDÉ DE DÉTECTION DE FISSURES DANS DES SUBSTRATS SEMI-CONDUCTEURS

(30) Priorität: 26.10.2009 DE 102009050711
(43) Veröffentlichungstag der Anmeldung: 05.09.2012
(73) Patentinhaber: SCHOTT AG, 55122 Mainz (DE)
(72) Erfinder: ORTNER, Andreas, 55435 Gau-Algesheim (DE); GERSTNER, Klaus, 65474 Bischofsheim (DE); VON CAMPE, Hilmar, 61352 Bad Homburg (DE); STELZL, Michael, 55129 Mainz (DE)
(74) Vertreter: Schmidt, Oliver
(86) Internationale Anmeldenummer: PCT/EP2010/004980
(87) Internationale Veröffentlichungsnummer: WO 2011/050873

(56) Entgegenhaltungen:
- WO-A1-2009/125896
- CN-A- 1 908 638
- DE-B3-102009 017 786
- DE-B4- 10 316 707
- DE-T5-112006 000 392
- JP-A- 8 220 008
- JP-A- 2001 305 072
- US-A- 5 355 213
- US-A1- 2005 231 713
- US-B2- 8 055 058
- RUELAND E ET AL.: "Optical (micro)-Crack detection in combination with stability testing for in-line-inspection of wafers and cells", 20TH EUROPEAN SOLAR ENERGY CONFERENCE AND EXHIBITION, 6 June 2005 (2005-06-06), - 10 June 2005 (2005-06-10), Barcelona, Spain
- RAKOTONIAINA J P ET AL.: "Distribution and formation of silicon carbide and silicon nitride precipitates in block-cast multicrystalline silicon", 20TH EUROPEAN PHOTOVOLTAIC SOLAR ENERGY CONFERENCE, 6 June 2005 (2005-06-06), - 10 June 2005 (2005-06-10), pages 773-776, Barcelona, Spain
- Lau W S: "Infrared Characterization for Microelectronics", 1999, World Scientific Publishing Co., Singapore ISBN: 981-02-2352-8 page 145,
- OGAWA et al.: "Infrared light scattering tomography with an electrical streak camera for characterization of semiconductor crystals", Rev. Sci. Instrum., vol. 57, no. 6, June 1986 (1986-06), pages 1135-1139,
- TAIJING et al.: "Oberservation of microdefects and microprecipitates in Si crystals by IR scat- tering tomography", Journal of Crystal Growth, vol. 108, no. 3-4, 1991, pages 482-490,
- NANGO et al.: "Detection of very small defects and tiny inclusions just under mirror polished surfaces of silicon wafers by inside total reflection", J. Appl. Phys., vol. 78, no. 4, 15 August 1995 (1995-08-15), pages 2892-2893,
- Gräff O.; Ortner A.: "Neues Infrarot-Prüfverfahren zur Detektion von Mikrorissen in Silizium-Wafer". (DGaO-Proceedings 2010)

## Beschreibung

Die Erfindung betrifft allgemein die Detektion von Fehlern in Halbleitersubstraten. Insbesondere betrifft die Erfindung die Erkennung und Lokalisierung von Rissen in Halbleitersubstraten, wie beispielsweise in Wafern.

Zur Detektion von Rissen in Halbleitersubstraten sind mechanische, insbesondere taktile und akustische Verfahren bekannt. So ist es beispielsweise aus der WO 2008/112597 A1 bekannt, die Resonanzfrequenzen eines Silizium-Wafers mit den Resonanzfrequenzen eines Referenz-Wafers zu vergleichen. Anhand von Abweichungen der Resonanzfrequenzen kann dann auf Risse geschlossen werden. Nachteilig ist hier die mechanische Belastung, die auch bei einem intakten Wafer gegebenenfalls zum Bruch führen kann.

Weiterhin sind optische Verfahren bekannt. So basiert die in der DE 01 46 879 A1 beschriebene Vorrichtung auf einer Durchlichtanordnung. Der Wafer wird von einer Seite mit Licht bestrahlt. Auf der gegenüberliegenden Seite ist eine Kamera angeordnet, welche das durch einen Riss hindurchtretende Licht erfasst. Hierbei ist allerdings Voraussetzung, dass der Riss durchgehend oder zumindest so tief ist, dass Licht durch den Riss hindurchdringen kann.

Andere im Aufbau ähnliche optische Verfahren basieren auf ebenfalls auf einer Hellfeld-Betrachtung, wobei der Wafer rückseitig jedoch mit Licht bestrahlt, welches aufgrund seiner Wellenlänge, bei welcher der Wafer transparent ist, durch den Wafer transmittiert wird. Der Wafer wird auf der gegenüberliegenden Seite optisch mittels einer Kamera analysiert. An einem Riss ändert sich die Transmission leicht, so dass der Riss mittels der Kamera erfasst werden kann. Eine solche Anordnung ist aus der JP 08220008 A bekannt. Nachteilig ist hier, dass das Signal der Transmissionsänderung von einem wesentlich größeren Untergrundsignal in Form des durch den Wafer regulär transmittierten Lichts überlagert wird. Dies erschwert gerade bei kleinen Rissen eine Detektion.

Die Anordnung der US 2005/0231713 A1 umfasst zwei Strahlungsquellen, von denen eine oberhalb, die andere unterhalb des Halbleitersubstrats angeordnet ist. Die Strahlung der unterhalb des Substrats angeordneten Quelle vermag eine Kamera oberhalb des Substrats nicht durchdringen. Die Kamera kann durch die Strahlung der ersten Quelle gewonnene Untersuchungsergebnisse mittels Software auswerten.

Die Vorrichtung der WO 2009/125896 A1 untersucht die Kanten von Wafern darauf, ob ein entdeckter Defekt ein Riss oder ein Partikeleinschluss ist. Die Untersuchung des Wafers wird vorgenommen, während dieser entlang eines Transportweges bewegt wird.

Der Fachartikel von Rueland et al.: "Optical (micro)-Crack detection in combination with stability testing for inline-inspection of wafers and cells" (20th European solar energy conference, 6. Juni 2005 - 10. Juni 2005 in Barcelona) behandelt die optische Untersuchung von Wafern hinsichtlich Mikrorissen. In dieser Publikation wird ausgeführt, dass im Wafer vorkommende Korngrenzen einen hohen Kontrast verursachen und daher weitere Untersuchungen zur Steigerung der Detektionsrate notwendig sind.

Der Fachartikel vonRakotoniaina J. P. et al.: "Distribution and formation of silicon carbide and silicon nitride precipitates in block-cast multicrystalline silicon" (20th European photovoltaic solar energy conference, 6. Juni 2005 - 10. Juni 2005 in Barcelona, S. 773-776) beschreibt die Untersuchung der Verteilung von Silikoncarbid- und Silikonnitridausfällungen oder -niederschlägen in block-cast silicon. Insbesondere SiC Filamente wachsen in großwinkligen Korngrenzen, so dass eine Entscheidung zwischen Störungen und Korngrenzen nicht getroffen werden kann.

Der Fachartikel von Lau, W. S.: "infrared Characterization for Microelectronics" (1999, World Scientific publishing Co., Singapore. ISBN:981-02-23528, S. 145) beschäftigt sich allgemein mit der Detektion von Kristalldefekten in Silizium und GaAs. Hierbei wird zwischen Einkristallen und polykristallinen Strukturen nicht unterschieden.

Der Beitrag "Neues Infrarot-Prüfverfahren zur Detektion von Mikrorissen in Silizium-Wafern", Gräff et al., aus den DGaO-Proceedings 2010 beschreibt ein Verfahren zur Detektion von Mikrorissen in Si-Wafern. Die Beleuchtung des Wafers kann dabei mittels eines Infrarot-Lasers so erfolgen, dass der Strahl einen grösseren Durchmesser aufweist als die Dicke des Wafers.

Der Erfindung liegt mithin die Aufgabe zugrunde, die Rissdetektion an Halbleitersubstraten dahingehend zu. verbessern, dass einerseits eine mechanische Belastung und andererseits ein hoher Signaluntergrund vermieden wird.

Diese Aufgabe wird durch den Gegenstand des Anspruchs 1 gelöst.

Im Unterschied zu optischen Detektoren aus dem Stand der Technik wird das Halbleitersubstrat, wie beispielsweise ein Halbleiterwafer, nicht quer zu den Seitenflächen durchleuchtet, sondern das Licht wird vielmehr entlang der Seitenflächen durch das Substrat geleitet. Sofern das Licht nicht an einem Riss oder einer anderen Fehlstelle gestreut wird, erfolgt Totalreflexion an den Seitenflächen und das Licht wird weitergeleitet. Demgemäß tragen im Wesentlichen nur die Fehlstellen selbst zu einem vom Detektor erfassbaren Signal bei. Damit wird ein hoher Untergrund bei der Signaldetektion vermieden.

Die Wahl der Lichtquelle hängt unter anderem vom Halbleitermaterial des Substrats ab. Laser sind allgemein günstig aufgrund der hohen Lichtintensität und Strahlparallelität.

Halbleiter sind typischerweise im Infrarotbereich transparent. Dies trifft auch auf den technologisch besonders relevanten Fall von Siliziumsubstraten zu. Erfindungsgemäß ist die Lichtquelle ein Infrarot-Laser, der den weiteren Vorteil einer hohen Lichtintensität bietet. Der Laser, beziehungsweise dessen Licht wird auf die Kantenfläche des Hableitersubstrats gerichtet und zuvor gegebenenfalls noch geformt, wie etwa fokussiert oder kollimiert, Als Infrarotlaser auch für Siliziumsubstrate sind beispielsweise Nd:YAG-Laser geeignet. Hier können die Laserübergänge bei 1320 nm und 1444 nm genutzt werden. Besonders bevorzugt werden aber Laserdioden. Diese sind wesentlich preiswerter als Nd:YAG-Laser und es sind auch Laserdioden im Infrarotbereich mit Wellenlängen oberhalb der Absorptionskante von Silizium erhältlich.

Es ist demgemäß vorgesehen, das Halbleitersubstrat mit einem Infrarotlaser als Lichtquelle zu durchleuchten. Um trotz der linienförmigen Durchleuchtung eine vollständige Erfassung des Halbleitersubstrats zu erhalten, wird dabei -vorzugsweise mittels einer Vorschubeinrichtung- während der Beleuchtung des Halbleitersubstrats mit dem Laserstrahl das Halbleitersubstrat und die Lichtquelle relativ zueinander in Richtung entlang der Seiten und quer zur Lichteinfallsrichtung bewegt werden, so dass die Einfallsposition des Lichtstrahls entlang der Kante des Halbleitersubstrats bewegt wird, und wobei die Vorrichtung eine Recheneinrichtung umfasst, welche dazu eingerichtet ist, ein Bild der vom optischen Detektor betrachteten Seite des Halbleitersubstrats aus den während des Vorschubs des Halbleitersubstrats entlang des vom Laserstrahl durchleuchteten Bereichs des Halbleitersubstrats aufgezeichneten Detektorsignalen zu erzeugen.

Als bildgebender optischer Detektor wird allgemein ein Detektor verstanden, dessen Messung derart lokalisiert erfolgt, dass die Messwerte zu einem Bild zumindest eines Teilbereiches der Oberfläche zusammensetzbar sind. Neben Zeilen- oder Matrixkameras können demgemäß beispielsweise auch Scanner, beziehungsweise die Oberfläche abrasternd erfassende optische Detektoren eingesetzt werden.

Es ist günstig, wenn die Detektion lokalisiert erfolgt, wenn also nicht die integrale Helligkeit des auf einer Seite des Halbleitersubstrats herausgestreuten Lichts, sondern vielmehr das aus einem Teilbereich herausgestreute Licht erfasst wird. Dies ist sinnvoll, da Streuung in geringem Masse unter anderem an intakten Stellen erfolgen kann. Je größer der erfasste Bereich ist, desto stärker wird dann auch das Untergrundsignal. Um eine lokalisierte Messung vorzunehmen, bietet es sich insbesondere an, das an einer Seitenfläche des Halbleitersubstrats herausgestreute Licht mit einen Matrix- oder Zeilensensor als bildgebendem Sensor zu erfassen. Mit dem Sensor kann dann ein Oberflächenbild der lokalen Streulichtintensität ermittelt werden, in welchem sich Risse mit erhöhter Streuung dann deutlich gegenüber ihrer Umgebung abheben. Allgemein kann also aus den vom bildgebenden optischen Detektor erhaltenen Bilddaten ein Riss durch eine Auswertung der lokalen Helligkeitsverteilung ermittelt werden. Eine Möglichkeit besteht beispielsweise darin, die Bilder mit einem Kantenfilter auszuwerten. Neben Matrix- oder Zeilensensoren sind aber auch die Oberfläche des Halbleitersubstrats abrasternde Sensoren denkbar.
In bevorzugter Weiterbildung wird Infrarotlicht mit einer Wellenlänge von zumindest 1,2 Mikrometern aus einer entsprechenden Lichtquelle in die Kantenfläche eingeleitet. Derartige Lichtquellen haben somit Wellenlängen welche oberhalb der Absorptionskante von Silizium bei etwa 1,1 Mikrometern Wellenlänge liegen.

Geeignet ist wiederum ein Nd:YAG-Laser, welcher auf einen Laserübergang bei einer Wellenlänge oberhalb der genannten 1,2 Mikrometer eingestellt wird, oder -besonders bevorzugteine Laserdiode.

Neben einer sukzessiven Abtastung des Halbleitersubstrats mittels eines Vorschubs und einem lokalisierten Lichtstrahl, wie ihn insbesondere ein Infrarot-Laser erzeugen kann, besteht gemäß einer anderen Ausführungsform auch die Möglichkeit, mit einem entlang der Kantenfläche verbreiterten Lichtstrahl einen großen Teil des Halbleitersubstrats oder sogar das gesamte Halbleitersubstrat zu durchleuchten. Dazu kann eine Strahlungsquelle, beziehungsweise vorzugsweise eine Lichtquelle vorgesehen werden, die einen Strahl erzeugt, welcher zumindest ein Drittel, vorzugsweise die gesamte Breite des Halbleitersubstrats gemessen entlang der Richtung senkrecht zur Lichteinstrahlrichtung beleuchtet. Die Erfassung des Streulichts kann dann mit einer während der Beleuchtung über das Substrat bewegten zeilenförmigen Abtastung durch den optischen Detektor erfolgen. Besonders geeignet ist hier aber zur Erzielung kurzer Messzeiten die Abbildung der Oberfläche des Halbleitersubstrats auf einen Matrix-Sensor als Bestandteil des optischen Detektors.
Ein solcher breiter Strahl gemäß dieser Ausführungsform der Erfindung kann beispielsweise durch die Aufweitung eines Laserstrahls in Richtung entlang der Kante des Halbleitersubstrats erfolgen. Eine weitere Möglichkeit besteht darin, eine Anordnung von Leuchtdioden zu verwenden. Diese können insbesondere in einer Reihe entlang der Kante des Halbleitersubstrats angeordnet sein und so die Kantenfläche beleuchten.

Besonders bei einer lokalen Detektion und/oder einer lokalen Beleuchtung des Substrats ist es weiterhin günstig, wenn eine Vorschubrichtung vorgesehen wird, mit welcher das Halbleitersubstrat relativ zur Lichtquelle in Richtung entlang der Seiten und quer zur Lichteinfallsrichtung bewegt wird, so dass die Einfallsposition des Lichtstrahls die Kante entlang bewegt wird. Das Substrat bewegt sich auf dieser Weise bei konstanten Beleuchtungsverhältnissen am Detektor vorbei, so dass sukzessive die gesamte Seite des Substrats oder zumindest der für eine Weiterverarbeitung relevante Bereich erfasst wird.

Insbesondere kann die Lichtquelle gegenüber dem optischen Detektor fest angeordnet sein, wobei eine Vorschubeinrichtung vorgesehen ist, mit welcher das Halbleitersubstrat relativ zur Anordnung mit Lichtquelle und optischem Detektor bewegt und die Detektorsignale von einer Recheneinrichtung aufgezeichnet werden. Die sukzessive gewonnenen Detektorsignale werden dann zu einem Oberflächenbild zusammengesetzt. Mittels der Recheneinrichtung kann dann aus der lokalen Helligkeitsverteilung im Oberflächenbild das Vorhandensein eines Risses erkannt werden.

Manche Halbleitersubstrate sind nur teiltransparent für geeignetes Licht. Um hier bei der Lichtleitung entlang der Seitenflächen über das gesamte Substrat hinweg noch hinreichende Lichtintensität zu haben, die eine Rissdetektion ermöglicht, können vorteilhaft mehrere Lichtstrahlen verwendet werden, die an verschiedenen Punkten der Kante eingekoppelt werden.

Insbesondere bietet es sich an, das Licht an gegenüberliegenden Punkten der Kante einzukoppeln. Dazu ist vorgesehen, dass die Strahlungsquelle, vorzugsweise Lichtquelle zwei gegenläufige Strahlen erzeugt, welche das Substrat in entgegengesetzter Richtung durchqueren. Dies ist auch bei einer hohen Transparenz des Substrats sinnvoll, da ein Riss wie ein Spiegel wirken kann. In diesem Fall sinkt die Lichtintensität in Einstrahlungsrichtung gesehen hinter dem Riss stark ab, so dass ein eventueller weiterer Riss hinter dem als Spiegel wirkenden ersten Riss gegebenenfalls nicht mehr erfasst wird. Noch ein weiterer Effekt, auch bei transparenten Substraten ist, dass es an der Einkoppelstelle am Substrat vielfach zu einer starken Streuung des Lichts in Richtung auf den Detektor kommt. Dies kann eine Übersteuerung des Detektors bei der Abtastung des Randbereichs an der Kante des Halbleitersubstrats bewirken. Werden aber mit den gegenläufigen Laserstrahlen unterschiedliche Bereiche des Halbleitersubstrats durchleuchtet, können jeweils die Randbereiche an der Lichtaustrittsstelle, an denen keine Übersteuerung auftritt, vom optischen Detektor erfasst werden. Dann kann ein Gesamtbild der Oberfläche aus zwei Teilbildern erstellt werden, wobei bei der Erstellung der Teilbilder jeweils die Randbereiche an den Eintrittsstellen der Laserstrahlen ausgeblendet werden. Demgemäß ist vorgesehen, dass zwei gegenläufige Laserstrahlen durch das Substrat geleitet werden, wobei mit einem bildgebenden Detektor das Streulicht beider Laserstrahlen selektiv erfasst wird, und wobei von den selektiv erfassten Detektorsignalen des Streulichts jedes der Laserstrahlen jeweils ein Teilbild der Oberfläche erzeugt wird und wobei die Teilbilder zu einem Gesamtbild zusammengesetzt werden.

Betrachtet man ein polykristallines Halbleitersubstrat, wie etwa einen polykristallinen Silizium-Wafer für die Solarzellenproduktion in Aufsicht, so sind die einzelnen Kristallite und entsprechend auch die Korngrenzen zwischen den Kristalliten deutlich sichtbar. Entsprechend kann es dann auch bei Auflicht- oder Durchlicht-Detektionsverfahren zu einer Verwechselung von Korngrenzen mit Rissen kommen. Es hat sich demgegenüber überraschend gezeigt, dass bei einem polykristallinen Halbleitersubstrat auch die Korngrenzen die Messung praktisch nicht beeinflussen. Eine Verwechselung einer Korngrenze mit einem Riss ist so praktisch ausgeschlossen. Demgemäß wird in vorteilhafter Weiterbildung der Erfindung ein polykristallines Halbleitersubstrat durchleuchtet und auf Risse untersucht wird.

Auch hat sich das Verfahren in besonderem Maße für die Inspektion von Solarzellen als geeignet erwiesen. Es hat sich gezeigt, dass auch die bereits aufgebrachten Kontaktfinger die Messung nicht stören. An den Kontaktfingern findet keine oder zumindest keine wesentliche zusätzliche Streuung statt, so dass eine Verwechselung eines Kontaktfingers der Solarzelle mit einem Riss vermieden wird.

Die Erfindung zeichnet sich gegenüber bekannten Rissdetektions-Systemen durch ein sehr hohes Signal-RauschVerhältnis aus. Dies ermöglicht dann auch eine sehr schnelle Inspektion von Halbleitersubstraten, wie insbesondere Wafern und Solarzellen. Es ist ohne weiteres möglich, Substrate mit einer Kantenlänge von 156 Millimetern innerhalb einer Sekunde oder weniger zu überprüfen. Demmgemäß ist in Weiterbildung der Erfindung vorgesehen, die Inspektion bei einer Vorschubgeschwindigkeit von mindestens 156 Millimetern pro Sekunde vorzunehmen.

Die Erfindung wird nachfolgend unter Bezugnahme auf die beigeschlossenen Zeichnungen näher erläutert. Dabei verweisen gleiche Bezugszeichen auf gleiche oder ähnliche Elemente. Es zeigen:
Fig. 1 einen schematischen Aufbau einer Vorrichtung,
Fig. 2 den Strahlengang in einem Halbleitersubstrat mit einem Riss,
Fig. 3 eine Aufnahme einer Wafers mit einem Riss,
Fig. 4 eine Anordnung zur Rissdetektion in Aufsicht auf ein Halbleitersubstrat,
Fig. 5 einen Vergleich einer aufgenommenen Oberfläche einer Solarzelle mit einer Elektrolumineszenzaufnahme,
Fig. 6A eine Elektrolumineszenz-Aufnahme einer Solarzelle,
Fig. 6B eine Überlagerung der in Fig. 6A gezeigten Aufnahme mit einer Aufnahme des Streulichts,
Fig. 7 eine Anordnung mit einem das Halbleitersubstrat schräg zur Vorschubrichtung durchleuchtenden Laserstrahl, und
Fig. 8 eine Anordnung mit rotierendem Halbleitersubstrat,
Fig. 9 und Fig. 10 zwei Varianten der in Fig. 1 dargestellten Vorrichtung,
Fig. 11 eine Variante der in Fig. 4 gezeigten Ausführungsform mit intermittierend getakteten, gegenläufigen, koaxialen Lichtstrahlen,
Fig. 12 das Zusammensetzen von Teilbildern, wie sie mit der in Fig. 11 gezeigten Anordnung gewonnen werden, zu einem Gesamtbild,
Fig. 13 eine Weiterbildung der in Fig. 11 gezeigten Ausführungsform,
Fig. 14 einen zeitlichen Ablauf von Triggersignalen,
Fig. 15 Erfindungsgemäsße Vorrichtung für die Einkopplung des Lichts in die Kantenfläche des Halbleitersubstrats,
Fig. 16 ein weiteres Ausführungsbeispiel der Lichteinkopplung.

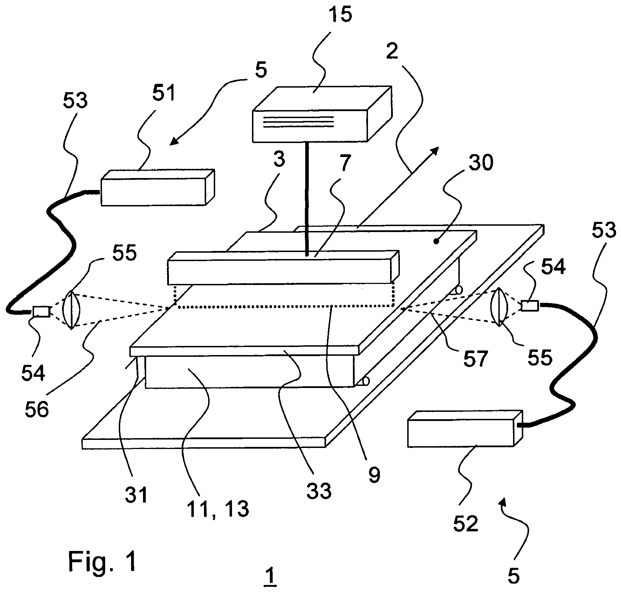

Fig. 1 zeigt den schematischen Aufbau einer Vorrichtung 1 zur Detektion von Rissen in flächigen Halbleitersubstraten. Auf einer geeigneten Einrichtung 11 wird ein Halbleitersubstrat 3, beispielsweise ein Siliziumwafer gelagert. Die Einrichtung 11 umfasst dazu einen Schlitten, auf welchem das Halbleitersubstrat 3 abgelegt ist. Der Schlitten ist entlang einer Vorschubrichtung 2 beweglich und stellt damit gleichzeitig eine Vorschubeinrichtung 13 dar, mit welcher das Halbleitersubstrat durch die Vorrichtung bewegt wird. Das flächige Halbleitersubstrat 3 umfasst zwei gegenüberliegende Seitenflächen 30, 31 und eine umlaufende Kantenfläche 33, deren Höhe der Dicke des Halbleitersubstrats 3 entspricht.

Die Vorrichtung 1 weist eine insgesamt mit dem Bezugszeichen 5 bezeichnete Lichtquelle für Infrarotlicht auf, die bezüglich der Einrichtung 11, beziehungsweise einem mit der Einrichtung 11 gelagerten Halbleitersubstrat so angeordnet ist, dass deren Licht seitlich in die Kantenfläche 33 eingekoppelt wird. Das Halbleitersubstrat 3 ist zumindest teiltransparent für das Licht der Lichtquelle 5, so dass das Licht mindestens bis zur Hälfte der Strecke zum der Eintrittsstelle gegenüberliegenden Stelle der Kante durch Lichtleitung unter Totalreflexion an den Seitenflächen 30, 31 in Richtung entlang dieser Seitenflächen 30, 31 geleitet wird.

Als optischer Detektor 7 ist bei dem in Fig. 1 dargestellten Beispiel eine Infrarot-empfindliche Zeilenkamera vorgesehen, welche einen linienförmigen Bereich 9 der Seite 30 erfasst. Der linienförmige Bereich 9 erstreckt sich allgemein quer, vorzugsweise, aber nicht notwendigerweise senkrecht zur Vorschubrichtung 2. Mit dieser Anordnung kann die Zeilenkamera Licht detektieren, welches an einem Riss gestreut wird und dann am Riss aus der Seite 30 austritt.

Anstelle einer Zeilenkamera kann auch eine Matrixkamera verwendet werden, bei welcher jeweils der vom Laserstrahl durchquerte Bereich des Bildfelds ausgelesen wird.

Im Speziellen umfasst hier die Lichtquelle zwei Infrarotlaser 51, 52. Geeignet sind beispielsweise Nd:YAG-Laser, die so eingestellt sind, dass sie bei einer Wellenlänge von mehr als 1,2 Mikrometern emittieren. Insbesondere können die Laserübergänge bei 1320 und 1444 Nanometern Wellenlänge verwendet werden. Leistungen um 10 Milliwatt können dabei bereits ausreichend sein, um eine hinreichende Durchleuchtung des Halbleitersubstrats zu erzielen. Ohne Beschränkung auf die in Fig. 1 dargestellte Variante ist vorzugsweise ein Infrarotlaser als Bestandteil der Beleuchtungsquelle vorgesehen, welcher eine Strahlungsleistung von mindestens 5 Milliwatt aufweist, um einen Halbleiterwafer seitlich zu durchleuchten und an einem Riss ein hinreichendes Lichtstreusignal hervorzurufen. Vorzugsweise werden aber Laserdioden als Lichtquelle verwendet, da diese wesentlich günstiger sind, als Nd:YAG-Laser und auch für den geforderten Wellenlängenbereich erhältlich sind.

Die Bewegung des Halbleitersubstrats 3 erfolgt entlang der Oberfläche des Substrats, so dass die Laserstrahlen 56, 57 im Verlauf des Vorschubs bei der Messung immer auf die Kantenfläche 33 treffen.

Die Zeilenkamera des optischen Detektors 7 ist mit einer Recheneinrichtung 15 verbunden. Die Recheneinrichtung 15 setzt die sukzessive im Verlauf des Vorschubs gewonnenen Detektorsignale in Form von Bildzeilen zu einem Oberflächenbild zusammen.

Um das Licht auf die Kantenfläche 33 zu richten, sind an die Infrarotlaser 51, 52 Lichtleiter-Fasern 53 mit Faserauskopplungen 54 vorgesehen. Den Faserauskopplungen 54 sind Strahlformungseinrichtungen 55 vorgeschaltet, welche die Strahlen 56, 57 auf gegenüberliegende Stellen der umlaufenden Kantenfläche 33 fokussieren und/oder kollimieren.

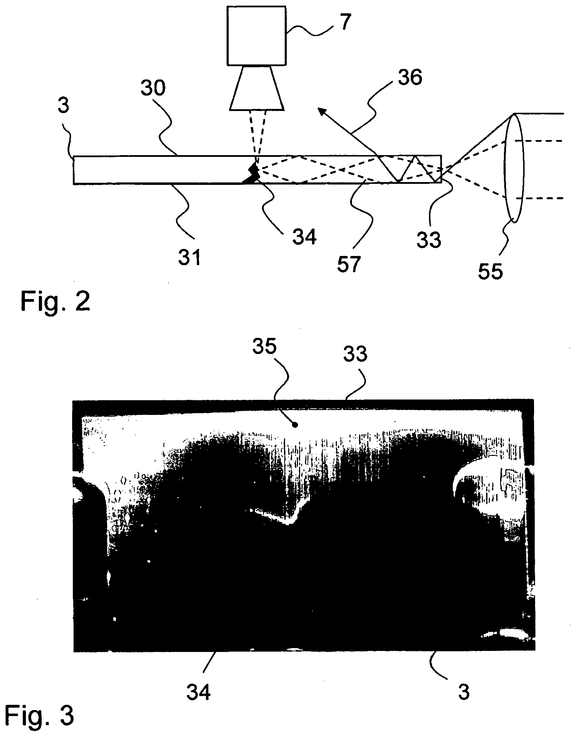

Fig. 2 zeigt den Strahlengang in einem Halbleitersubstrat 3 mit einem Riss 34. Der Laserstrahl 57 wird, wie auch anhand von Fig. 1 dargestellt, in die Kantenfläche 33 eingekoppelt. Innerhalb des Halbleitersubstrats 3 wird der Laserstrahl 57 durch Totalreflexion an den Seitenflächen 30, 31 geführt. Im Halbleitersubstrat 3 verläuft ein Riss 34. Am Riss 34 kommt es zu strahlablenkenden Effekten wie Streuung oder Reflexion. Damit wird ein Teil des Strahls 57 am Riss 34 unter so großem Winkel auf die Seitenflächen gerichtet, dass der Grenzwinkel der Totalreflexion überschritten und der Strahl austritt. Das austretende Licht wird dann vom auf die Seitenfläche 30 blickenden optischen Detektor 7 erfasst. In der Abbildung der Seite 30 zeigt sich der Riss 34 dann als hell hervortretende Struktur.

Ein durch Zusammensetzen von Bildzeilen erstelltes Bild eines Wafers einer Solarzelle zeigt Fig. 3. Die Bildzeilen wurden sukzessive während des Vorschubs mit einer Infrarot-Matrixkamera aufgenommen. Der Matrixsensor dieser Kamera ist ein InGaAs-Quantendetektor. Dabei wurde ein linienförmiger Bereich des Sensors ausgewählt, auf welchem der vom Laserstrahl durchleuchtete Bereich abgebildet wird. Um bei Matrixsensoren die Empfindlichkeit und damit die erzielbare Abtastgeschwindigkeit zu erhöhen, kann, wie auch im dargestellte Bild pro Bildzeile des Oberflächenbilds eine Mittelung über mehrere, beispielsweise drei benachbarte Bildzeilen vorgenommen werden.

In der Aufnahme der Fig. 3 wurde der Laserstrahl in der im Bild oben befindlichen Seite der Kantenfläche 33 eingestrahlt.

Wie anhand von Fig. 3 zu erkennen ist, kann ein Riss 34 mit hohem Kontrast ohne weiteres erkannt werden. Auch die Kontaktfinger der Solarzelle, die sich auf der Oberfläche des Halbleitersubstrats 3 befinden, stören die Messung nicht.

Allerdings ist in der Nähe der Kantenfläche 33, in welche der Laserstrahl eingekoppelt wird, ein heller Bereich 35 erkennbar, in welchem es auch zu einer Übersteuerung des Sensors kommen kann. In diesem Randbereich können dann aufgrund der Übersteuerung Risse eventuell nicht erkannt werden. Diese Übersteuerung im Randbereich wird insbesondere durch Strahlen verursacht, welche unter einem Winkel größer als der Winkel für Totalreflexion in das Halbleitersubstrat eingekoppelt werden. Ein derartiger Teilstrahl 36, der nach der Einkopplung in das Halbleitersubstrat 3 wieder austreten kann, ist in Fig. 2 eingezeichnet.

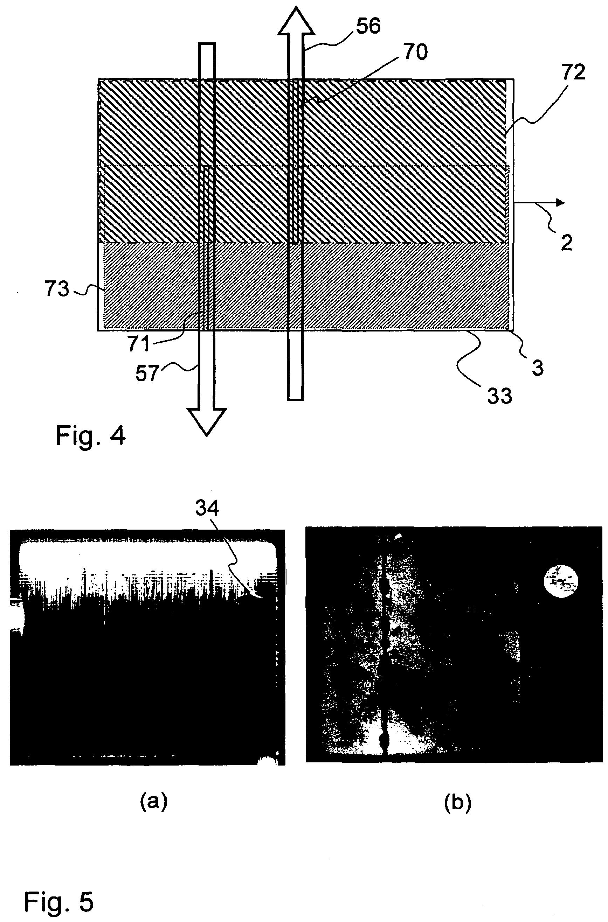

Prinzipiell kann diesem Effekt durch geeignete Kollimation und/oder Fokussierung begegnet werden. Eine weitere, alternative oder zusätzliche Möglichkeit mit einer wie in Fig. 1 dargestellten Anordnung mit zwei gegenläufigen Laserstrahlen zeigt die Anordnung gemäß Fig. 4. Das Messprinzip dieser in Fig. 4 dargestellten Anordnung basiert darauf, dass zwei gegenläufige Laserstrahlen durch das Substrat geleitet werden, wobei mit einem bildgebenden Detektor das Streulicht beider Laserstrahlen selektiv erfasst wird, und wobei von den selektiv erfassten Detektorsignalen des Streulichts jedes der Laserstrahlen jeweils ein Teilbild der Oberfläche erzeugt und die Teilbilder zu einem Gesamtbild zusammengesetzt werden.

Ohne Beschränkung auf die in Fig. 4 gezeigte Variante ist es zur Erstellung der Teilbilder hier günstig, die beiden Laserstrahlen 56, 57 zwar gegenläufig, aber entlang der Vorschubrichtung versetzt durch das Halbleitersubstrat 3 zu leiten.

Zur Erstellung des Streulicht-Bildes wird vorzugsweise ein Matrixsensor verwendet. Möglich ist aber auch, für jeden der von den Laserstrahlen 56, 57 durchleuchteten Bereiche eine Zeilenkamera vorzusehen. Im Falle eines Matrixsensors werden vom Sensor zwei linienförmige Bereiche 70, 71 ausgelesen, auf welche die von den Laserstrahlen 56, 57 durchleuchteten Bereiche des Halbleitersubstrats 3 abgebildet werden. Beispielsweise können zwei oder mehr benachbarte Bildzeilen als Bereiche 70, 71 ausgelesen werden. Über die mehreren Bildzeilen kann dann noch zur Verbesserung des Rauschabstands zwischen entlang der Vorschubrichtung 2 benachbarten Pixeln gemittelt werden.

Wie anhand von Fig. 4 zu erkennen ist, werden die Bildzeilen nicht über die gesamte Länge der durchleuchteten Bereiche hinweg ausgewertet. Vielmehr wird bei beiden Strahlen 56, 57 der Rand des Halbleitersubstrats, an welchem der jeweilige Strahl eintritt, ausgespart.

Andererseits kann auch der überstrahlte, beziehungsweise übersteuerte Bereich an der Kante des Halbleitersubstrats ausgewertet werden. Befinden sich in diesem Bereich Risse, so können diese zu Abschattungen führen, die im Bild als Hell-Dunkel-Kante sichtbar sind.

Während des Vorschubs des Halbleitersubstrats werden beide linienförmigen Bereiche 70, 71 dann zyklisch, beziehungsweise sukzessive ausgelesen. Die ausgelesenen linienförmigen Bereiche 70, 71, beziehungsweise deren Signale können dann zu zwei Teilbildern 71, 73 zusammengesetzt werden, wobei das Teilbild 72 aus ausgelesenen linienförmigen Bereichen 70 und das Teilbild 73 aus ausgelesenen linienförmigen Bereichen 71 zusammengesetzt wird. Die beiden Teilbilder 70, 71 können dann zu einem Gesamtbild der Streulichtverteilung kombiniert werden. Die beiden Teilbilder 72, 73 können auch, wie auch im Beispiel der Fig. 4 gezeigt ist, überlappen. Dies kann günstig sein, um das Zusammenfügen der Teilbilder 72, 73 zu erleichtern oder um Artefakte an einer Nahtstelle der Teilbilder zu vermeiden.

Eine weitere verbreitete Überprüfungsmethode, die bei Solarzellen Anwendung findet, ist die fotographische Aufnahme der Elektrolumineszenz. Dabei wird die Solarzelle umgekehrt wie eine Leuchtdiode betrieben und das abgestrahlte Elektrolumineszenlicht aufgenommen.
Fig. 5 zeigt dazu einen Vergleich der Resultate dieses Verfahrens und der erfindungsgemäßen Rissdetektion. Das mit (a) gekennzeichnete linke Bild ist ein Abbild einer Solarzelle mit einem Riss 34. Das mit (b) gekennzeichnete Bild auf der rechten Seite ist eine ElektrolumineszenzAufnahme der Solarzelle. Es fällt auf, dass der Riss in der Elektrolumineszenz-Aufnahme kaum zu erkennen ist. Ein kreisförmiger Bereich im Bild, innerhalb welchem auch der Riss verläuft, wurde im Kontrast hervorgehoben. Selbst mit dem verstärkten Kontrast ist der Riss kaum zu erkennen. Zudem werden Helligkeitsvariationen durch die polykristalline Struktur verursacht.

Beim Elektrolumineszenzverfahren werden Helligkeitskontraste nebeneinanderliegender Bereiche mit abwechselnd strahlender und nicht-strahlender Rekombination erzeugt.

Neben der strahlenden Rekombination von Elektron-Loch-Paaren (Lumineszenz) erfolgt nicht-strahlende Rekombination an Kristalldefekten wie rekombinationsaktiven Korngrenzen oder Versetzungen. Auch Risse können anhand nicht-strahlender Rekombination in Rissnähe sichtbar werden. Weitere Hell-/Dunkelkontraste entstehen bei unterbrochenen Strompfaden wie unterbrochenen Leiterbahnen, z. B. der einzelnen Finger des Frontgitters. Auch Störungen der Oberfläche bilden sich im Elektrolumineszenzbild als dunkler Kontrast ab.

Um diese zahlreichen Kontrastursachen zu unterscheiden, wird versucht, durch Bildauswerte-Algorithmen Risse von den anderen Strukturen zu trennen. Dieses kann jedoch lediglich aufgrund einer Form- bzw. Kontrastbetrachtung erfolgen, so daß das Verfahren derzeit nicht effektiv ist und zu erheblichen Fehlidentifikationen führt.

Eigene im Ablauf sehr zeitaufwendige Untersuchungen durch Kombination von Elektrolumineszenzbildern mit Mikroskopie und Elektronenmikroskopie haben ergeben, dass bei besonders schmalen Rissen eine eindeutige Identifikation nicht in allen Fällen möglich war, d. h. nicht alle makroskopischen Risse, die im Elektrolumineszenzbild vermutet wurden, konnten mit den o. g. Methoden identifiziert werden.

Hingegen war bei Einsatz der vorliegenden Erfindung eine eindeutige Identifizierung genau dieser Risse auf einfache und schnelle Weise möglich.

Es ist daher ein großer Vorteil der Kombination aus Elektrolumineszenzaufnahme und dem erfindungsgemäßen Rissdetektionsverfahren, dass in nur einem Detektionsvorgang und mit einer Versuchsanordnung
1. alle relevanten Störungen der Solarzelle erkannt werden können,
2. darunter befindliche Risse problemlos detektiert werden können, und
3. defekte Solarzellen nach klaren Kriterien aussortiert werden können.

Ein unsicherer mathematischer Formalismus kann durch die eindeutige Identifikationsmethode ersetzt werden, was in einem Produktionsprozess die Ausbeute an guten Zellen deutlich anhebt.

Für die Rissdetektion bei Solarwafern ergibt sich aus der Möglichkeit der Kombination von Photolumineszenz-Bildern und/oder Infrarot-Durchlichtbildern mit rückseitiger Beleuchtung in Hell- und/oder Dunkelfeld-Anordnung und/oder Mikrowellen-Lebensdauermappings mit der Erfindung eine analoge Möglichkeit zur eindeutigen Identifikation und Aussortierung.

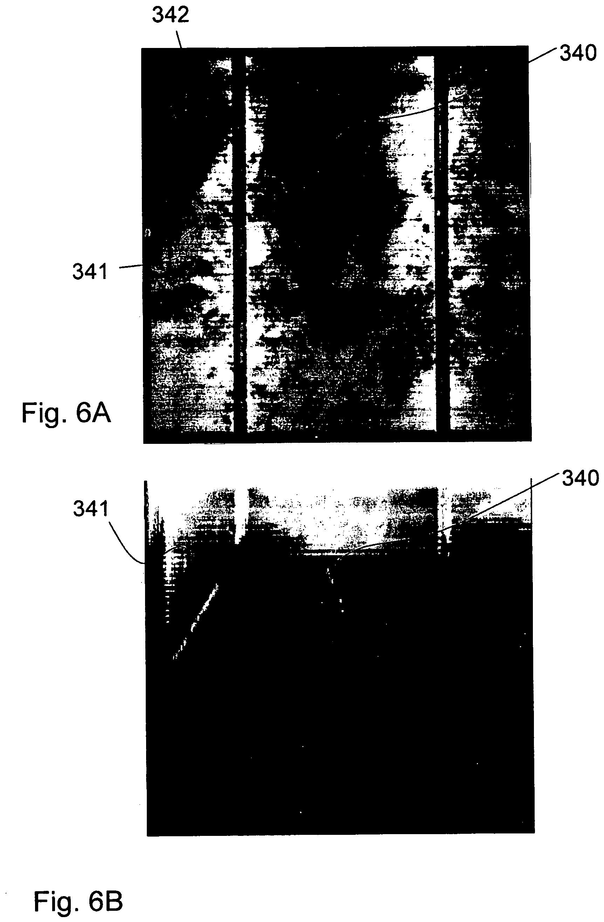

Zur Verdeutlichung ist in Fig. 6A eine weitere Elektrolumineszenz-Aufnahme einer rissbehafteten Solarzelle dargestellt. Die Solarzelle weist zwei Risse 340, 341 auf. Fig. 6B zeigt eine Bildmontage der ElektrolumineszenzAufnahme mit der Abbildung der erfindungsgemäßen Rissdetektion durch Erfassung des Streulichts bei seitlicher Durchleuchtung. Die Strukturen des Elektrolumineszenzbildes sind als dunkle Kontraste, die Risse als helle Linien in Fig. 6B dargestellt.

In Weiterbildung der Erfindung wird somit eine Kombination des erfindungsgemäßen Durchleuchtungsverfahrens mit einer Elektrolumineszenz-Aufnahme und/oder den weiteren oben genannten Verfahren der Infrarot-Durchleuchtung vorgeschlagen. Demgemäß wird gemäß dieser Ausführungsform der Erfindung zusätzlich zur Aufnahme des Streulichts zumindest eine Elektrolumineszenz-Aufnahme und/oder eine Photolumineszenz-Aufnahme und/oder eine Hell- oder Dunkelfeld-Aufnahme, insbesondere unter rückseitiger Durchleuchtung oder Auflicht-Beleuchtung durchgeführt. Rückseitige Durchleuchtung mit Infrarotlicht bedeutet hier eine Beleuchtung der Seitenfläche des Halbleiter-Substrats, welche der Seitenfläche, die der optische Detektor betrachtet, gegenüberliegt. Damit wird eine Hellfeld-Aufnahme realisiert.

Auf diese Weise können neben Rissen auch andere Defekte, wie insbesondere Ablösungen von Kontakten, sofort erkannt werden. Ist der elektrische Kontakt der Anschlußstrukturen, typischerweise Kontaktbalken und Kontaktfinger, gestört oder unterbrochen, kann dies mit einer Elektrolumineszenzaufnahme anhand einer lokalen oder globalen Verdunkelung im Elektrolumineszenzbild schnell und sicher erkannt werden. Bei dem in Fig. 6A gezeigten Bild unterbricht als Beispiel der Riss 341 auch die Kontaktierung der Solarzelle im Bereich 342 links des Risses. Dieser nicht kontaktierte Bereich 342 erscheint daher in der Elektrolumineszenz-Aufnahme dunkel.

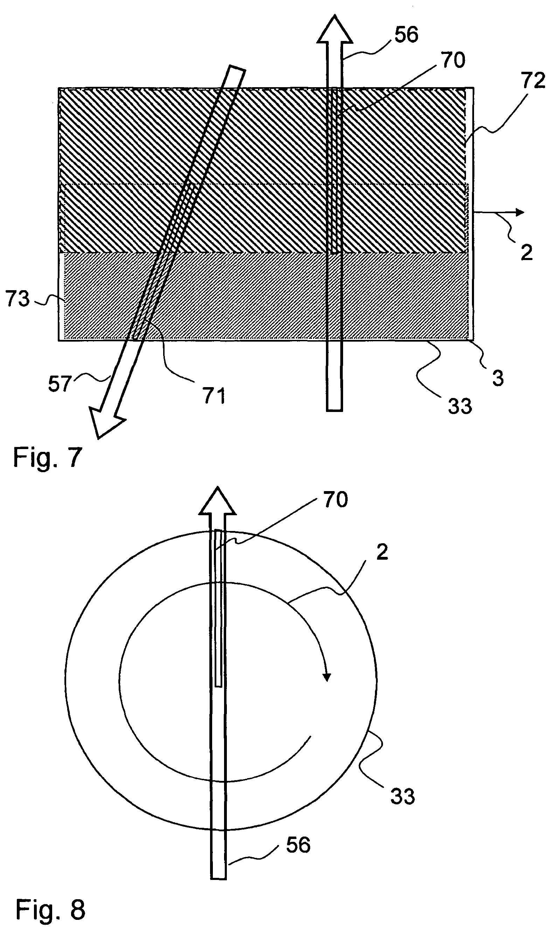

Sofern ein Riss parallel zur Durchstrahlrichtung des Strahls verläuft, kann die Streueffizienz sehr gering sein, so dass möglicherweise trotz des mit dem erfindungsgemäßen Meßverfahren erzielbaren Kontrasts ein derartiger Effekt nicht sicher erkennbar ist. Um dies zu verhindern, kann es sinnvoll sein, das Halbleitersubstrat mit einem Laserstrahl quer zur Vorschubrichtung zu durchleuchten. Fig. 7 zeigt ähnlich zu Fig. 4 eine solche Konfiguration in Aufsicht, wobei das Halbleitersubstrat 3 in diesem Beispiel wieder von zwei Laserstrahlen 56, 57 durchleuchtet wird und zumindest einer der Laserstrahlen, hier der Laserstrahl 57 schräg zur Vorschubrichtung das Halbleitersubstrat 3 durchleuchtet.

In den vorangegangenen Beispielen wurden das Halbleitersubstrat 3 und die Laserstrahlen relativ zueinander in linearer Bewegung aneinander vorbeigeführt. Die Vorschubrichtung kann allerdings auch eine Rotation sein. Eine solche Bewegung ist insbesondere bei runden Wafern, wie sie vielfach zur Fertigung elektronischer Komponenten und integrierter Schaltkreise verwendet werden, günstig. Fig. 8 zeigt in Aufsicht eine solche Anordnung. Die Kantenfläche 33 des runden Halbleitersubstrats 3 wird hier durch eine Rotation entlang der kreisförmigen Vorschubrichtung 2 am Laserstrahl 56 vorbeibewegt. Dies bietet den Vorteil, dass der Abstand zwischen der Kantenfläche 33 und dem Laser wie bei einer geraden Kantenfläche und linearem Vorschub konstant gehalten werden kann. Um ein Gesamtbild des Halbleitersubstrats zu erhalten, kann beispielsweise im Sensor ein linienförmiger Bereich gewählt werden, welcher von der Lichtaustrittstelle auf der Kantenfläche 33 bis zum Drehpunkt oder darüber hinaus reicht.

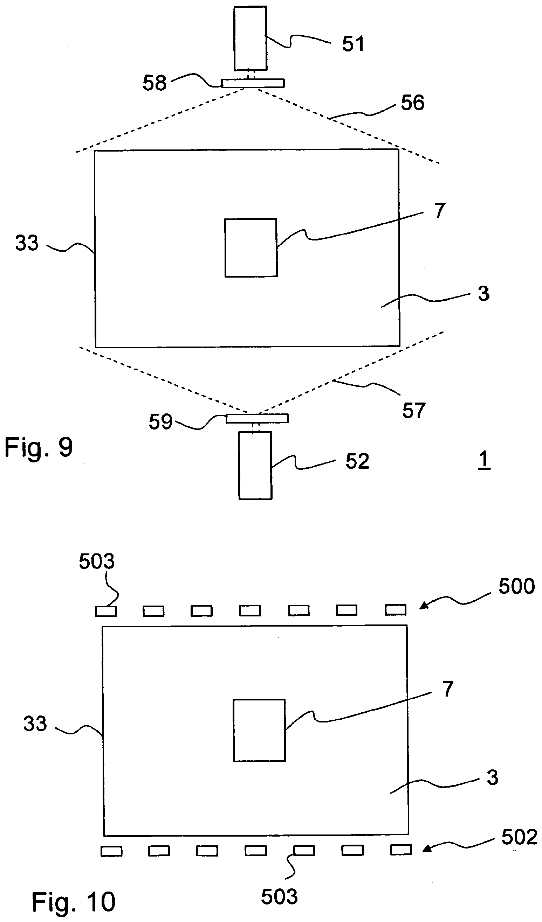

Die Fig. 9 und 10 zeigen in Aufsicht zwei Varianten der in Fig. 1 dargestellten Vorrichtung 1. Beide Varianten basieren darauf, dass die Lichtquelle zwei Strahlen erzeugt, welche jeweils die gesamte Breite des Halbleitersubstrats gemessen entlang der Richtung senkrecht zur Lichteinstrahlrichtung beleuchtet.

Bei der in Fig. 9 gezeigten Variante der Vorrichtung 1 werden ähnlich zu der in Fig. 1 gezeigten Variante zwei Infrarotlaser 51, 52 verwendet, welche die Kantenfläche 33 des Halbleitersubstrats 3 von gegenüberliegenden Seiten beleuchten. Zusätzlich sind Strahlaufweitungseinrichtungen 58, 59 vorgesehen, mit welchen die Laserstrahlen 56, 56 in Richtung entlang der Kante aufgeweitet werden. Die Strahlen 56, 57 wurden dabei so weit aufgeweitet, dass jeder der in das Halbleitersubstrat 3 eingekoppelten Strahlen das Halbleitersubstrat vollständig durchleuchtet. Der optische Detektor 7 kann somit ein vollständiges Bild der Streulichtverteilung bereits mit einer einzelnen Aufnahme erhalten. Um den Überstrahlungseffekt, wie er in Fig. 3 zu sehen ist, zu vermeiden, können zwei Aufnahmen gemacht werden, bei welchen die Laser 56, 57 abwechselnd ausgeschaltet sind, so dass in jeder Aufnahme das Halbleitersubstrat jeweils mit einem anderen Laser durchleuchtet wird.

Um den Strahl aufzuweiten, können als Strahlaufweitungseinrichtungen 58, 59 beispielsweise geeignete diffraktive optische Elemente oder zylindrische Linsen eingesetzt werden. Eine andere Möglichkeit besteht in der Verwendung eines Lichtleiter-Arrays.

Bei der Variante der Fig. 10 werden anstelle der Laser zwei Reihen 500, 502 von Leuchtdioden 503 eingesetzt werden. Die in Reihe angeordneten Leuchtdioden erstrecken sich bei der gezeigten Variante entlang der Kantenfläche 33. Die Aufnahme des Gesamtbildes der Streulichtverteilung kann zur Vermeidung eines Überstrahlungseffektes ebenso wie bei dem in Fig. 9 gezeigten Beispiel mit abwechselndem Betrieb der Reihen 500, 502 durchgeführt werden. Leuchtdioden, wie sie für dieses Beispiel verwendbar sind, sind ebenso wie Laserdioden für Wellenlängen von 1200 Nanometern und mehr erhältlich.

Bei der in in Fig. 4 gezeigten Variante wurden die beiden Laserstrahlen 56, 57 zwar gegenläufig, aber entlang der Vorschubrichtung versetzt durch das Halbleitersubstrat 3 geleitet.

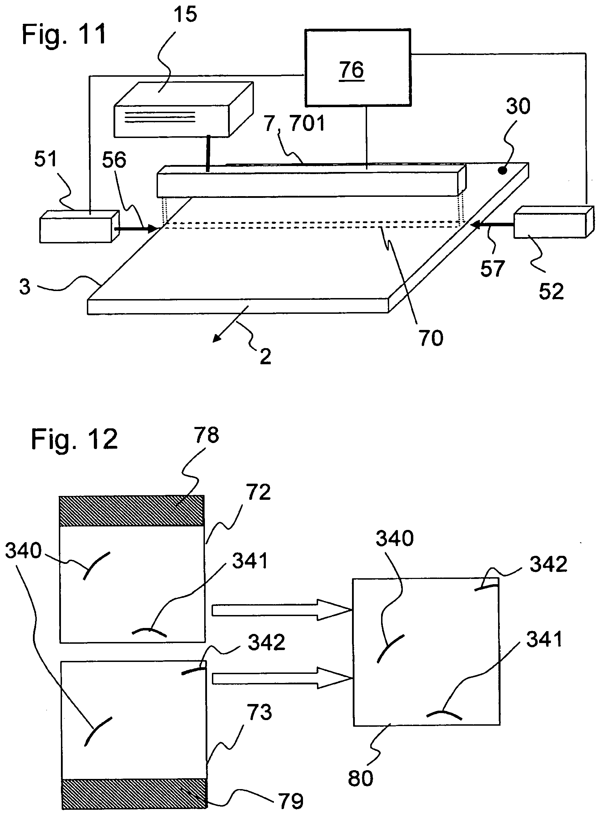

Fig. 11 zeigt eine weitere Variante, welche auf einer intermittierenden Beleuchtung durch zwei wiederum gegenläufige Lichtstrahlen 56, 57 basiert. Dazu ist
eine Triggereinrichtung 76 vorgesehen. Diese ist eingerichtet zum intermittierenden Takten der zwei Strahlen. Die beiden Strahlungsquellen, vorzugsweise Lichtquellen, besonders bevorzugt Laser, beleuchten von gegenüberliegenden Seiten ineinander verlaufend, beziehungsweise koaxial das Messobjekt, jedoch nicht gleichzeitig, sondern abwechselnd. Um hohe Messfrequenzen zu erhalten, werden modulierbare Laserquellen bevorzugt.

Der optische Detektor 7 wird durch die Triggereinrichtung 76 synchron mit der Taktung der zwei Strahlen getaktet, so dass vom Detektor intermittierend Detektorsignale des Streulichts des ersten Lichtstrahls 56 und des zweiten Lichtstrahls 57 erzeugt werden. Als Detektor eignet sich hier insbesondere eine Zeilenkamera 701. Die Lichtstrahlen 56, 57 sind hier nicht nur gegenläufig, sondern auch koaxial. Wie bei den vorhergehenden Beispielen ist eine Recheneinrichtung 15 vorgesehen, welche die sukzessive im Verlauf des Vorschubs gewonnenen Detektorsignale in Form von Bildzeilen zu einem Oberflächenbild zusammensetzt.

Dabei können die Randbereiche des Halbleitersubstrats 3, in welchen bei der Aufnahme ein Übersteuern beim Lichteintritt auftritt, jeweils durch Bilddaten ersetzt werden, welche mit dem gegenüberliegend eingekoppelten, am jeweiligen Randbereich austretenden Lichtstrahl gewonnen wurden. Die jeweils zu den Lichtpulsen der beiden Lichtstrahlen 56, 57 aufgenommenen Bildzeilen können dabei zeilenweise direkt zum Gesamtbild zusammengesetzt werden, oder es können zwei Teilbilder mit mehreren Bildzeilen erstellt werden, die dann zusammengefügt werden. Das Zusammenfügen der beiden Teilbilder 72, 73, welche jeweils die StreulichtIntensität eines der beiden Lichtstrahlen 56, 57 wiedergeben, zu einem Gesamtbild 80 ist in Fig. 12 dargestellt. In den Teilbildern 72, 73 wird, um ein Gesamtbild zusammenzusetzen, jeweils nur ein Teil der Detektorsignale berücksichtigt, so dass jeweils Streifen 78, 79, in denen eine Übersteuerung am Lichteintrittsbereich des Halbleitersubstrats 3 auftritt, ausgeblendet werden. Auch die übersteuerten Bereiche können aber, wie oben bereits dargelegt, zusätzlich auf das Vorliegen von Rissen ausgewertet werden, indem durch Risse verursachte Abschattungen gesucht werden.

Ein Vorteil dieser zweikanaligen, getakteten Messvorrichtung mit gegenläufigen Messtrahlen besteht darin, dass die zu den beiden Lichtstrahlen 56, 57 abwechselnd gewonnenen Detektorsignale zum gleichen linienförmigen Bereich 70 gehören. Eine Verschiebung von Teilbildern vor dem Zusammensetzen, so dass diese für das Zusammensetzen des Gesamtbilds zusammenpassen, kann demgemäß hier entfallen.

Die Verwendung eines Infrarot-Matrixdetektors bringt neben hohen Anschaffungskosten gegenüber einer Zeilenkamera auch die Nachteile einer verringerten Ortsauflösung und geringeren Messfrequenz (=Bildaufnahmerate) mit sich, d.h. es müssen zumindest Teilbilder oder auch das Vollbild eingelesen und ausgewertet werden. Moderne Infrarot-Zeilenkameras bieten im Vergleich zu Matrixdetektoren die Vorteile hoher Bildauflösung (hohe Pixelzahl pro Längeneinheit) und typischerweise deutlich höhere Zeilenfrequenzen bei geringeren Anschaffungskosten.

Die Steuerung der Lichtquellen, wie vorzugsweise der Infrarotlaser 51, 52, insbesondere hinsichtlich der Modulation, Belichtungszeit, Laserleistung, sowie der Zeilenkamera 701 kann mittels geeigneter Triggersignale wie z.B. TTL-Signal erfolgen. Die Bildaufnahme in den einzelnen Beleuchtungstakten durch die Zeilenkamera 701 kann gemäß einem Ausführungsbeispiel durch einen ein CameraLink(CL)-FrameGrabber erfolgen, der mittels geeigneter Software oder auch in Form eines programmierten FPGAs die eingelesenen Zeilendaten der Kamera zu zwei Bildern des Messobjektes in den unterschiedlichen Beleuchtungszuständen zusammenstellt.

Jedes der beiden Bilder wird ausgewertet hinsichtlich Defekten im Messobjekt, wie etwa der in Fig. 12 gezeigten Risse 340, 341, 342 und erlaubt die Detektion von Defekten auch im Randbereich der jeweils nicht beleuchteten Kante des Messobjektes, also des Halbleitersubstrats 3, so dass insgesamt alle Kanten des Halbleitersubstrats 3 inspiziert werden.

Wie bereits weiter oben erwähnt, kann die Erfindung auch mit weiteren Messverfahren, wie etwa der Erfassung der Elektrolumineszenz, Infrarot-Durchlichtbildern mit Beleuchtung der Rückseite, Mikrowellen-Lebensdauer-Mapping, sowie auch mit Auflicht-Bildern kombiniert werden. Dies ist insbesondere auch mit einer Erweiterung der vorstehend beschriebenen Vorrichtung mit getakteter, intermittierender Signalaufzeichnung möglich. Dies wird nachfolgend genauer erläutert. Die Erfindung basiert darauf, dass abwechselnd Lichtsignale der einen oder wie in der Variante gemäß Fig. 11 zwei gepulsten, seitlich durchleuchtenden Infrarot-Lichtquellen und zumindest ein weiteres Lichtsignal einer anderen Lichtquelle aufgezeichnet werden. Aus den intermittierend erhaltenen Signalen der Lichtquellen können dann jeweils Bilder des Messobjekts, hier also des Halbleitersubstrats erstellt werden, die zu den unterschiedlichen Lichtquellen korrespondieren. Im Falle der Elektrolumineszenz und des Mikrowellen-angeregten Lebensdauer-Mappings stellt das Halbleitersubstrat selbst die Lichtquelle dar.

Um neben der erfindungsgemäßen Erfassung des Streulichts unter seitlicher Durchleuchtung weitere Lichtsignale zu erfassen, werden entsprechend weitere Triggersignale vorgesehen. Demgemäß ist eine Triggereinrichtung 76 vorgesehen, die Triggersignale ausgibt, welche den Detektor 7 synchron mit der InfrarotLichtquelle 5 takten, wobei die Triggereinrichtung 76 außerdem in den Zwischenräumen zwischen den Triggerimpulsen mit welchen der Detektor synchron mit der InfrarotLichtquelle getaktet wird, weitere Triggerimpulse an den Detektor 7 ausgibt, so dass der Detektor 7 während der Zeiträume, in welchen die Infrarot-Lichtquelle 5 ausgeschaltet ist, jeweils Licht derweiteren Lichtquelle detektiert. Zusätzlich können weitere Lichtquellen getriggert, oder gegebenenfalls auch ungetriggert betrieben, eingesetzt werden. Wird eine ungetriggerte Lichtquelle verwendet, die also auch Lichtsignale liefert, während das Streulicht aus der getriggert betriebenen seitlich durchleuchtenden Infrarot-Lichtquelle aufgezeichnet wird, können die jeweiligen Signale der Lichtquellen dann durch einfache Differenzbildung der Detektorsignale extrahiert werden.

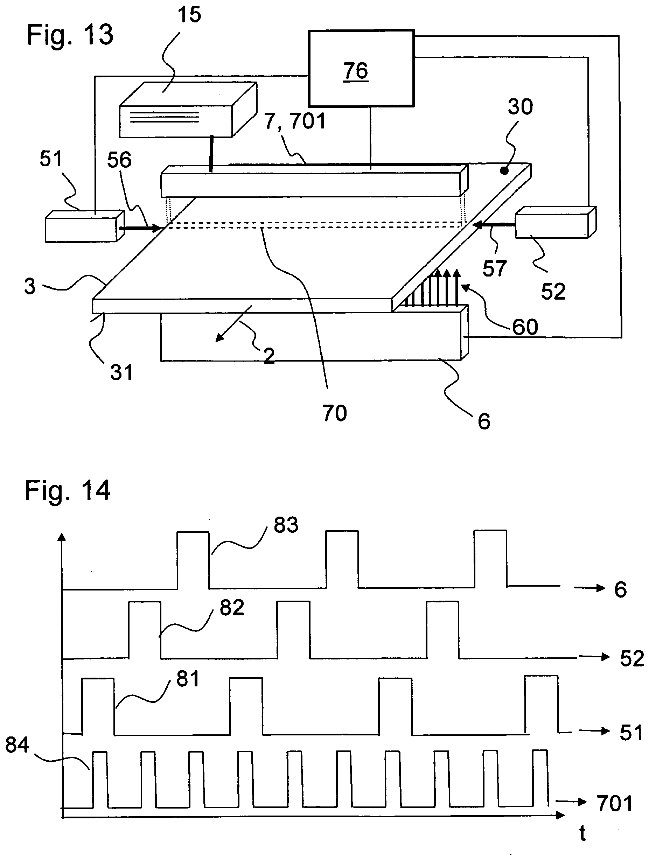

Ein beispielhafter Aufbau wird anhand der Fig. 13 und 14 erläutert. Die Anordnung der Vorrichtung gemäß Fig. 13 entspricht der Variante gemäß Fig. 11. Zusätzlich zu den beiden in die gegenüberliegenden Kantenflächen des Halbleitersubstrats 3 eingekoppelten Lasern 51, 52 ist eine weitere Lichtquelle in Form einer Hellfeld-Infrarotlichtquelle 6 vorgesehen. Diese Hellfeld-Infrarotlichtquelle 6 beleuchtet mit einem Lichtstrahl 60 die der Seitenfläche 30, welche vom optischen Detektor 7, beziehungsweise hier der Zeilenkamera 701 betrachtet wird, gegenüberliegende Seitenfläche 31. Der Lichtstrahl 60 ist zweckmäßigerweise fächerförmig aufgeweitet, so dass der von der Zeilenkamera 7 erfasste linienförmige Bereich vom Lichtstrahl 60 rückseitig vollständig ausgeleuchtet wird.

Hierzu kann beispielsweise das Licht einer IR-Lichtquelle, gegebenenfalls geführt von einer Lichtleitfaser, mit einer Stablinse aus Kamerasicht auf die rückseitige Seitenfläche 31 auf das Halbleiter-Substrat 3 gerichtet werden, so dass von der Zeilenkamera 701 ein Durchlichtbild des Wafers aufgenommen wird. Neben der in Fig. 13 beispielhaft gezeigten Aufbauvariante zur zusätzlichen Aufnahme von Durchlicht-Hellfeld-Bildern sind Kombinationen mit weiteren Messverfahren wie Durchlicht-Dunkelfeld-Aufnahmen, Photo-oder Elektrolumineszenz möglich. Bei einer Durchlicht-Dunkelfeld-Aufnahme wird der Lichtstrahl der Lichtquelle 6 so auf die aus Sicht des optischen Detektors 7 rückseitige Seitenfläche 31 gerichtet, dass es nach störungsfreiem Durchgang am optischen Detektor 7 vorbeigeht.

Die Steuerung aller Lichtquellen und die Bildaufnahme durch den Infrarotsensor kann auch hier mittels eines CL-Framegrabbers und geeigneter Software erfolgen. Vorteile der Kombination der erfindungsgemäßen Beleuchtung der Kantenflächen mit anderen IR-Durchlichtaufnahmen liegen in den erweiterten Detektionsmöglichkeiten hinsichtlich von Defekten wie Kratzer, Löcher, Einschlüsse, etc..

Um die Hellfeld- Infrarotlichtquelle 6 anzusteuern, ist diese ebenso wie die beiden Infrarot-Laser 51, 52 mit der Triggereinrichtung 76 verbunden.

Eine beispielhafte zeitliche Abfolge der von der Triggereinrichtung 76 ausgegebenen Trigger- oder Taktsignale ist in Fig. 14 dargestellt. Neben den vier dargestellten Triggerimpulsserien sind mit Bezugszeichen diejenigen Komponenten gekennzeichnet, an welche die Triggerimpulse gesendet werden. Demnach wird die zuoberst im Diagramm dargestellte Impulsserie von der Triggereinrichtung an die Hellfeld-Lichtquelle 6 gesendet, die darunter dargestellte Serie an den zweiten Infrarotlaser 51, die wiederum darunter dargestellte Serie an den ersten Infrarotlaser 51 und die unterste Serie an den optischen Detektor 7, beziehungsweise im Speziellen die Zeilenkamera 701. Wie zu erkennen ist, sind die Triggerimpulse 81, 82, 83 der Impulsserien, welche an die Lichtquellen 6, 51, 52 gesendet werden und für die Dauer der Impulse ein Anschalten der jeweiligen Lichtquelle bewirken, zueinander zeitversetzt, so dass die Lichtquellen intermittierend betrieben werden. Die an die Zeilenkamera 710 gesendeten Triggerimpulse 84 sind jeweils synchron mit den Triggerimpulsen 81, 82, 83, so dass bei jedem Einschalten jeder der Lichtquellen 6, 51, 52 eine Bildzeile von der Zeilenkamera 701 aufgezeichnet wird.

Demgemäß werden von der Triggereinrichtung 76 in den zeitlichen Zwischenräumen zwischen den Triggerimpulsen mit welchen der Detektor 7, beziehungsweise hier speziell die Zeilenkamera 701 synchron mit der Infrarot-Lichtquelle 5, beziehungsweise hier dem Infrarotlaser 51, oder dem Infrarotlaser 52 getaktet wird, weitere Taktimpulse an den Detektor 7 ausgegeben, so dass der Detektor 7 während der Zeiträume, in welchen die Infrarot-Lichtquelle 5 (also im Beispiel der Fig. 13 die Infrarotlaser 51, 52) ausgeschaltet ist, jeweils Licht einer weiteren Lichtquelle (im Beispiel der Fig. 13 dementsprechend die Hellfeld-Lichtquelle 6) detektiert. Selbstverständlich kann bei dem in Fig. 13 gezeigten Beispiel auch die Hellfeld-Lichtquelle 6 durch andere Lichtquellen ersetzt oder ergänzt werden. Werden weitere Lichtquellen verwendet, kann die zeitliche Abfolge der Triggerimpulse, wie sie beispielhaft in Fig. 14 gezeigt ist, entsprechend angepasst werden, so dass sukzessive Bildzeilen unter Beleuchtung der nacheinander eingeschalteten Lichtquellen aufgenommen werden.

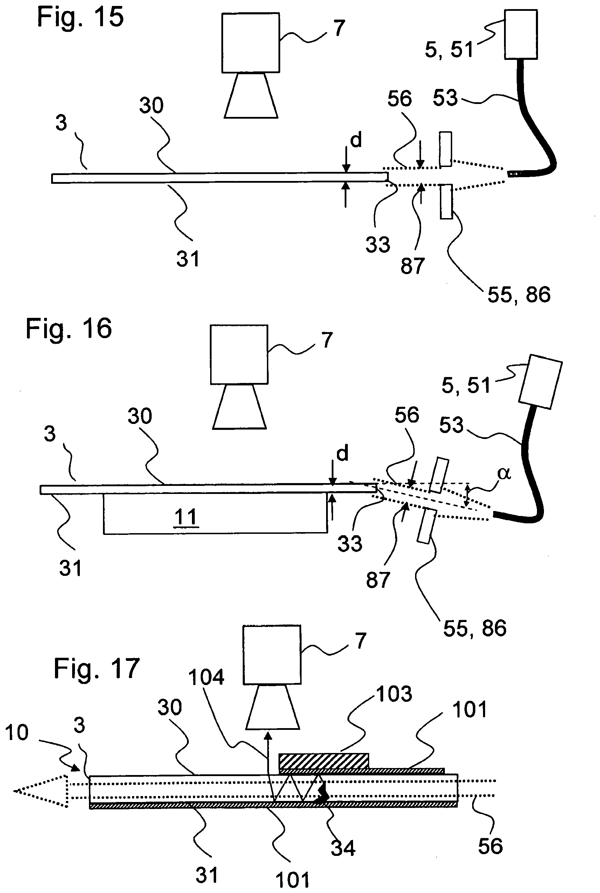

Bei den in Fig. 1 und 2 gezeigten Varianten wurden Fokussierungseinrichtungen als Strahlformungseinrichtungen 55 verwendet, welche die Strahlen 56, 57 der Lichtquelle 5 auf gegenüberliegende Stellen der umlaufenden Kantenfläche 33 fokussieren. In Fig. 15 ist eine Alternative der Einkopplung des Lichts in die Kantenfläche 33 dargestellt. Der parallele Lichtstrahl 56 der Lichtquelle 5 wird nicht auf die Kantenfläche 33 derart fokussiert, dass der Durchmesser des Strahlflecks auf der Kantenfläche 33 kleiner als die Dicke des Halbleitersubstrats 3 ist. Vielmehr wird allgemein mittels einer geeignet ausgebildeten Lichtquelle 5 ein Lichtstrahl 56 auf die Kantenfläche 33 gerichtet, dessen Ausdehnung auf der Kantenfläche 33 in Richtung senkrecht zu den Seitenflächen größer als die Dicke d des Halbleitersubstrats 3 ist.

Zu der in Fig. 15 gezeigten Vorrichtung ist ein Kollimator 86 als Strahlformungseinrichtung 55 vorgesehen, welcher dem Austrittsende des Lichtleiters 53 vorgeschaltet. Mit dem Kollimator wird ein paralleler oder zumindest annähernd paralleler Lichtstrahl 56 erzeugt. Dessen Strahldurchmesser 87 ist aber trotz der Kollimation größer als die Dicke d des Halbleitersubstrats 3, also des Abstands der Seitenflächen 30,31. Die Verwendung eines Lichtstrahls 56 mit einer solchen großen Ausdehnung zur Inspektion von Halbleitersubstraten hat zur Folge, dass auch bei Lageveränderung des Halbleitersubstrates 3 in Richtung senkrecht zu den Seitenflächen die Einkopplung des Lichts in das Halbleitersubstrat 3 gewährleistet bleibt.

Ein Parallelstrahl, wie er in dem in Fig. 15 gezeigten Beispiel mit dem Kollimator erzeugt wird, ist weiterhin günstig, um die Einkopplung auch unempfindlicher gegenüber Lageänderungen in Richtung entlang des Lichteinfalls zu machen, denn der parallelisierte Strahl weist die geringste mögliche Divergenz auf. Mit diesen Maßnahmen, also allgemein der Einkopplung eines parallelen Lichtstrahls mit einer Strahlausdehnung, die in Richtung senkrecht zu den Seitenflächen größer ist, als die Dicke des Halbleitersubstrats, wird die Messfeldtiefe maximiert und die Anordnung vergleichsweise unempfindlich in Bezug auf die Ausrichtung der Halbleitersubstrate.

Vorzugsweise ist die Ausdehnung des Lichtstrahls senkrecht zu den Seitenflächen (bei einem runden Lichtstrahl entsprechend also der Strahldurchmesser) zumindest 1,5 mal, besonders bevorzugt zumindest 3 mal größer als die Dicke des Halbleitersubstrats 3. Beispielsweise kann bei einer Dicke des Halbleitersubstrats 3 von 200 Mikrometern ein Strahl mit einem Strahldurchmesser von 800 Mikrometern eingesetzt werden.

Fig. 16 zeigt eine weitere Variante der Lichteinkopplung, die entsprechend auch auf die in den Fig. 1 und 2 gezeigten Fokussierung des Lichtstrahls auf die Kantenfläche angewendet werden kann. Wie anhand von Fig. 16 ersichtlich, ist die Lichtquelle so angeordnet, dass der Lichtstrahl 56 schräg auf die Kante 33 des Halbleitersubstrats 3, beziehungsweise unter einem Winkel zu den Ebenen der Seitenflächen 30, 31 trifft. Die schräge Beleuchtung des Halbleitersubstrats 3 hat sich als günstig erwiesen, störende Beleuchtungseffekte wie z. B. Reflexionen von Streulicht durch die Oberfläche des Halbleitersubstrats 3 oder an der Einrichtung 11 zur Lagerung des Halbleitersubstrats 3 zu minimieren. Die schräge Beleuchtung ist auch insbesondere von Vorteil, wenn, wie auch im Beispiel der Fig. 15 ein Lichtstrahl verwendet wird, dessen Ausdehnung auf der Kantenfläche 33 in Richtung senkrecht zu den Seitenflächen 30, 31 größer als die Dicke d des Halbleitersubstrats 3 ist. Bei einer Beleuchtung parallel zu den Seitenflächen 30, 31, wie sie in Fig. 15 gezeigt ist, kann es zu Lichtstreuung der ober- und unterhalb am Halbleitersubstrat 3 vorbeigestrahlten Anteile des Lichtstrahls 56 an Strukturen auf den Seitenflächen 30, 31 kommen. Beispiele solcher Strukturen sind allgemein Rauhigkeiten, sowie Kontakte und Sammelschienen, wie sie etwa vielfach auf Solarzellen vorhanden sind. Diese gestreuten Lichtanteile können ebenfalls vom optischen Detektor 7 erfasst werden. Gegebenenfalls kann dies zu Fehlinterpretationen führen.

Als Neigungswinkel α gegenüber den Ebenen der Seitenflächen werden Winkel von zumindest 3° oder größer bevorzugt.

Damit der Lichtstrahl 56 ungestört eingekoppelt werden kann, ist es günstig, wenn, wie in Fig. 16 gezeigt, die Kante 33 des Halbleitersubstrats 3 frei im Raum steht, beziehungsweise von der Auflage der Einrichtung 11 übersteht.

Weiterhin hat es sich noch als etwas günstiger zur Vermeidung von Streueffekten erwiesen, wenn, wie in Fig. 16 dargestellt, der Lichtstrahl von der dem Detektor 7 abgewandten Seite her beleuchtet wird. Mit anderen Worten ist die Lichteinfallsrichtung von der durch den Detektor betrachteten Seitenfläche 30 weg geneigt. Auf diese Weise fällt kein Licht auf die dem optischen Detektor 7 zugewandten Seite, so dass an dieser Seite eine Streuung an oberflächlichen Strukturen auch im Bereich des einfallenden Lichtstrahls an der Kante des Halbleitersubstrats vermieden wird.

Es wurde gefunden, dass es insbesondere bei der Verwendung von Lasern infolge der Streuung des intensiven Infrarotlichts an Rissen möglich ist, sogar solche Risse festzustellen, die durch darüber liegende, lichtundurchlässige Strukturen, wie angelötete Serienverbinder, auch Sammelschienen genannt, oder auch Kontaktfinger verdeckt sind.

Das am Riss gestreute Licht wird bei Solarzellen über den Rückkontakt oder allgemein der dem Detektor abgewandten Seitenfläche in Richtung auf den Detektor reflektiert und kann so an einer Seite der Abdeckung aus der Solarzelle heraustreten.

Dies wird an dem Beispiel in Fig. 17 erläutert:
Eine Solarzelle 10 mit einem Halbleitersubstrat 3 ist mit Frontkontakt 100 und Rückkontakt 101 versehen. Auf der Vorderseite und auch auf der Rückseite sind jeweils Serienverbinder 103 angelötet. Die Serienverbinder 103 sind zum Beispiel 2 mm breit und 200 *µ*m dick. Befindet sich ein Riss 34 unterhalb des dem Detektor zugewandten Serienverbinders 103, so dass er vom Detektor 7 nicht direkt erkannt werden kann, so kann dennoch dieser Riss 34 dadurch erkannt werden, dass an der Oberfläche des Halbleitersubstrats ein Teil des intensiven Laserlichtes zurückgestreut wird, wobei das gestreute Licht 104 unter Umständen, wie in Fig. 17 gezeigt, auch mehrfach zwischen den Kontakten reflektiert wird.

Auch aufgrund der typischerweise vorhandenen mikroskopischen Rauhigkeit der Halbleiter-Oberflächen kann das Licht auch in Richtung der IR-Kamera 40 aus der Oberfläche austreten, wodurch sich der Riss verrät.

Gemäß dieser Weiterbildung der Erfindung wird ein Riss unter einem Serienverbinder oder allgemeiner unter einer lichtundurchlässigen Struktur auf der dem Detektor 7 zugewandten Seitenfläche des Halbleitersubstrats wird also dadurch erkannt, dass der Rand der lichtundurchlässigen Struktur aufleuchtet, wenn ein unter der lichtundurchlässigen Struktur liegender Riss Lichtstreuung verursacht.

Es ist dem Fachmann ersichtlich, dass die Erfindung nicht auf die vorstehend beschriebenen Ausführungsformen beschränkt ist, sondern vielmehr in vielfältiger Weise im Rahmen der nachstehenden Ansprüche verändert werden kann. Insbesondere können die Merkmale einzelner Ausführungsbeispiele auch miteinander kombiniert werden.

### Bezugszeichenliste:

- 1: Vorrichtung zur Detektion von Rissen in flächigen Halbleitersubstraten
- 2: Vorschubrichtung
- 3: Halbleitersubstrat
- 5: Lichtquelle
- 6: Hellfeld-Lichtquelle
- 7: Zeilenkamera
- 9: linienförmiger, von 7 erfasster Bereich
- 10: Solarzelle
- 11: Einrichtung zur Lagerung von 3
- 13: Vorschubeinrichtung
- 15: Recheneinrichtung
- 30: Seitenfläche von 3
- 33: Kante von 3
- 34, 340, 341: Riss
- 35: heller Bereich von 3 an der Kante des Halbleitersubstrats,
- 36: Teilstrahl des Laserstrahls
- 51, 52: Infrarotlaser
- 53: Lichtleiter-Faser
- 54: Faserauskopplung
- 55: Strahlformungseinrichtung
- 56, 57: Strahlen von 51, 52
- 58, 59: Strahlaufweitungseinrichtungen
- 60: Lichtstrahl von 6
- 70, 71: linienförmige Bereiche auf Sensor
- 72, 73: Teilbilder
- 76: Triggereinrichtung
- 78, 79: ausgeblendete Bereiche in 72,73
- 80: aus 72, 73 zusammengesetztes Gesamtbild
- 81,82, 83,84: Triggerpulse
- 86: Kollimator
- 87: Strahldurchmesser
- 100: Frontseitenkontakt von 10
- 101: Rückseitenkontakt von 10
- 103: Serienverbinder von 10
- 104: an 34 gestreutes Licht
- 342: nicht kontaktierter Bereich auf Solarzelle
- 500, 502: Reihen von Leuchtdioden
- 503: Leuchtdiode
- 701: Zeilenkamera

## Patentansprüche

1. Verfahren zur Detektion von Rissen (34) in flächigen Halbleitersubstraten (3) mit zwei gegenüberliegenden Seitenflächen (30, 31) und einer umlaufenden Kantenfläche (33),
bei welchem
- elektromagnetische Strahlung in die Kantenfläche des Halbleitersubstrats (3) eingeleitet wird, wobei
- die elektromagnetische Strahlung eine Wellenlänge aufweist, welches durch das Material des Halbleitersubstrats (3) zumindest teilweise transmittiert wird, so dass
- die elektromagnetische Strahlung von der Eintrittsstelle an der Kantenfläche (33) bis mindestens zur Hälfte der Strecke bis zum gegenüberliegenden Punkt der Kantenfläche (33) durch Reflexion an den Seitenflächen (30, 31) geleitet wird, und wobei
- mittels eines auf die eingeleitete elektromagnetische Strahlung empfindlichen bildgebenden optischen Detektors (7) in Form eines Zeilensensors Strahlung detektiert wird, welche an einem Riss (34) gestreut wird und an einer der Seitenflächen (30, 31) am Rissort austritt, und wobei ein Bild der Streuintensität zumindest eines Bereichs der vom optischen Detektor betrachteten Seitenfläche aus den vom optischen Detektor (7) aufgenommenen Signalen erstellt wird, wobei das Halbleitersubstrat mit einem Laserstrahl (56) durchleuchtet wird, dessen Ausdehnung auf der Kantenfläche (33) in Richtung senkrecht zu den Seitenflächen (30, 31) des Halbleitersubstrats (3) größer als die Dicke d des Halbleitersubstrats (3) ist, um auch bei Lageveränderung des Halbleitersubstrates (3) in Richtung senkrecht zu den Seitenflächen die Einkopplung des Lichts in das Halbleitersubstrat (3) zu gewährleisten, und wobei
- mittels einer Vorschubeinrichtung (13) während der Beleuchtung des Halbleitersubstrats (3) mit dem Laserstrahl das Halbleitersubstrat (3) und die Lichtquelle (5) relativ zueinander in linearer Bewegung in Richtung entlang der Seiten und quer zur Lichteinfallsrichtung bewegt werden, so dass die Einfallsposition des Lichtstrahls entlang der Kante des Halbleitersubstrats (3) bewegt wird, und wobei die Vorrichtung eine Recheneinrichtung umfasst, welche ein Bild der vom optischen Detektor (7) betrachteten Seite des Halbleitersubstrats aus den während des Vorschubs des Halbleitersubstrats entlang des vom Laserstrahl durchleuchteten Bereichs des Halbleitersubstrats aufgezeichneten Detektorsignalen erzeugt, wobei
die Lichtquelle (5) gegenüber dem optischen Detektor (7) fest angeordnet ist, so dass der vom Laserstrahl durchleuchtete Bereich des Halbleitersubstrats während des Vorschubs im vom optischen Detektor (7) erfassten Bereich ortsfest bleibt, und wobei die Vorschubeinrichtung das Halbleitersubstrat relativ gegenüber der Anordnung aus Lichtquelle und Detektor bewegt, und die Recheneinrichtung sukzessive Detektorsignale aufzeichnet und zu einem Oberflächenbild zusammensetzt, wobei die Lichtquelle (5) eine Infrarot-Lichtquelle (5) ist, die zwei koaxiale gegenläufige Laserstrahlen (56, 57) erzeugt, die durch das Halbleitersubstrat (3) geleitet werden, wobei mit einem optischen Detektor (7) das Streulicht beider Laserstrahlen (56, 57) selektiv erfasst wird, und wobei von den selektiv erfassten Detektorsignalen des Streulichts jedes der Laserstrahlen (56, 57) jeweils ein Teilbild (72, 73) der Oberfläche erzeugt wird, und wobei die Teilbilder (72, 73) zu einem Gesamtbild zusammengesetzt werden, wobei
- eine Triggereinrichtung (76) vorgesehen ist, die intermittierend die beiden Laserstrahlen (56, 57) taktet, wobei
- synchron mit der Taktung der zwei Laserstrahlen (56, 57) der optische Detektor (7) getaktet wird, so dass vom optischen Detektor (7) intermittierend Detektorsignale des Streulichts des ersten und zweiten Laserstrahls (56, 57) erzeugt werden, wobei die Triggereinrichtung (76) außerdem Triggersignale ausgibt, welche den optischen Detektor (7) synchron mit der Infrarot-Lichtquelle (5) takten und in den Zwischenräumen zwischen den Triggersignalen, mit welchen der optische Detektor (7) synchron mit der Infrarot-Lichtquelle (5) getaktet wird, weitere Triggersignale an den optischen Detektor (7) ausgibt, so dass der optische Detektor (7) während der Zeiträume, in welchen die Infrarot-Lichtquelle (5) ausgeschaltet ist, jeweils Licht einer weiteren Lichtquelle detektiert.

2. Verfahren gemäß Anspruch 1, **dadurch gekennzeichnet, dass** Infrarotlicht einer Wellenlänge von zumindest 1,2 Mikrometern in die Kantenfläche (33) eingeleitet wird.

3. Verfahren gemäß einem der vorstehenden Ansprüche, **dadurch gekennzeichnet, dass** aus den vom bildgebenden optischen Detektor (7) erhaltenen Bilddaten ein Riss (34) durch eine Auswertung der lokalen Helligkeitsverteilung ermittelt wird.

4. Verfahren gemäß einem der vorstehenden Ansprüche, **dadurch gekennzeichnet, dass** zusätzlich zumindest eine Elektrolumineszenz-Aufnahme und/oder eine Photolumineszenzaufnahme und/oder eine Hell- oder Dunkelfeld-Aufnahme durchgeführt wird.

5. Verfahren gemäß einem der vorstehenden Ansprüche, wobei ein Riss unter einer lichtundurchlässigen Struktur auf der dem Detektor (7) zugewandten Seitenfläche des Halbleitersubstrats (3) anhand des Aufleuchtens des Rands der lichtundurchlässigen Struktur erkannt wird.

## Claims

1. A method for detecting cracks (34) in planar semiconductor substrates (3) which have two opposite faces (30, 31) and a circumferential edge surface (33); wherein
- electromagnetic radiation is introduced into the edge surface of the semiconductor substrate (3); wherein
- the electromagnetic radiation has a wavelength that is at least partially transmitted through the material of the semiconductor substrate (3), so that
- the electromagnetic radiation is directed from its point of incidence at the edge surface (33) over at least half the distance to the opposite point of the edge surface (33) by reflection at the faces (30, 31); and wherein
- by means of an imaging optical detector (7) in the form of a line sensor which is sensitive to the introduced electromagnetic radiation, radiation is detected which has been scattered at a crack (34) and exits from one of the faces (30, 31) at the location of the crack; and
wherein an image of the scattered intensity of at least a portion of the face that is viewed by the optical detector is generated from the signals captured by the optical detector (7);
wherein the semiconductor substrate is irradiated with a laser beam (56) which has a dimension on the edge surface (33) in a direction perpendicular to the faces (30, 31) of the semiconductor substrate (3) that is larger than the thickness d of the semiconductor substrate (3), in order to ensure injection of light into the semiconductor substrate (3) even if the semiconductor substrate (3) is displaced in a direction perpendicular to the faces; and
wherein
- during irradiation of the semiconductor substrate (3) by the laser beam, the semiconductor substrate (3) and the light source (5) are translated relative to each other in a direction along the faces and transversely to the direction of incidence of the light, by advancement means (13), so that the point of incidence of the light beam moves along the edge of the semiconductor substrate (3); and
wherein the apparatus comprises a computing device which generates an image of the face of the semiconductor substrate that is viewed by the optical detector (7) on the basis of the detector signals captured along the area of the semiconductor substrate passed by the laser beam during the advancement of the semiconductor substrate; wherein the light source (5) is arranged in fixed relationship to the optical detector (7), so that the area of the semiconductor substrate passed by the laser beam during the advancement remains stationary within the area covered by the optical detector (7); and wherein the advancement means moves the semiconductor substrate relative to the arrangement of light source and detector; and wherein the computing device successively records detector signals and to combine them into a surface image, wherein the light source (5) is an infrared light source (5) generating two coaxial laser beams (56, 57)in opposite directions, the laser beams (56, 57) passed through the semiconductor substrate (3), wherein the scattered light of the two laser beams (56, 57) is selectively captured by an imaging detector; and wherein a respective partial image (72, 73) of the surface is produced from the selectively captured detector signals of the scattered light of each of the laser beams (56, 57); and wherein the partial images (72, 73) are combined into a complete image, wherein trigger means are provided which intermittently clock the two beams, wherein the optical detector (7) is clocked in synchronism with the clocking of the beams (56, 57) so that the detector intermittently generates detector signals of the scattered light of the first and second light beams, wherein the trigger means (76), wherein the trigger means (76) moreover output clock pulses which clock the detector (7) in synchronism with the infrared light source (5) and output further trigger pulses to the detector (7)within the intervals between the trigger pulses which clock the detector (7) in synchronism with the infrared light source (5), so that during each of the intervals in which the infrared light source (5) is switched off the detector (7) detects light from another light source.

2. The method according to claim 1, **characterised in that** infrared light having a wavelength of at least 1.2 micrometres is introduced into the edge surface (33).

3. The method according to any one of the preceding claims, **characterised in that** a crack (34) is detected by evaluating the local brightness distribution of image data obtained by the imaging optical detector (7).

4. The method according to any one of the preceding claims, **characterised by** additionally performing at least electro-luminescent imaging and/or photo-luminescent imaging, and/or bright- or dark-field imaging.

5. The method according to any one of the preceding claims, wherein a crack beneath an opaque structure on the face of the semiconductor substrate (3) that faces the detector (7) is identified from a gleaming periphery of the opaque structure.

## Revendications

1. Procédé de détection de fissures (34) dans des substrats à semi-conducteurs plats (3) comprenant deux surfaces latérales (30, 31) opposées et une surface de bord (33) périphérique,
selon lequel :
- un rayonnement électromagnétique est introduit dans la surface de bord du substrat à semi-conducteurs (3), où
- le rayonnement électromagnétique présente une longueur d'onde qui est transmise au moins en partie par le matériau du substrat à semi-conducteurs (3), de sorte que
- le rayonnement électromagnétique est guidé du point d'entrée au niveau de la surface de bord (33) jusqu'à au moins la moitié du trajet jusqu'au point opposé de la surface de bord (33) par réflexion sur les surfaces latérales (30, 31), et où
- le rayonnement, lequel est dispersé sur une fissure (34) et sort au niveau d'une des surfaces latérales (30, 31) à l'emplacement de la fissure, est détecté au moyen d'un détecteur optique (7) produisant une image, sensible au rayonnement électromagnétique introduit et se présentant sous forme d'un capteur linéaire, et où une image de l'intensité de dispersion d'au moins une zone de la surface latérale observée par le détecteur optique est établie à partir des signaux enregistrés par le détecteur optique (7), où le substrat à semi-conducteurs est pénétré par un faisceau laser (56) dont l'étendue sur la surface de bord (33) dans une direction perpendiculaire aux surfaces latérales (30, 31) du substrat à semi-conducteurs (3) est supérieure à l'épaisseur d du substrat à semi-conducteurs (3), afin de garantir l'injection de la lumière dans le substrat à semi-conducteurs (3) dans une direction perpendiculaire aux surfaces latérales, y compris en cas de modification de la position du substrat à semi-conducteurs (3), et où
- le substrat à semi-conducteurs (3) et la source de lumière (5) sont déplacés l'un par rapport à l'autre dans un mouvement linéaire dans une direction longeant les faces et transversalement à la direction d'incidence de lumière au moyen d'un dispositif d'avance (13) pendant que le substrat à semi-conducteurs (3) est éclairé par le faisceau laser, de sorte que la position d'incidence du faisceau lumineux est déplacée le long du bord du substrat à semi-conducteurs (3), et où le dispositif comprend un système de calcul qui produit une image de la face du substrat à semi-conducteurs observée par le détecteur optique (7) à partir des signaux de détecteur enregistrés pendant l'avance du substrat à semi-conducteurs le long de la zone du substrat à semi-conducteurs pénétrée par le faisceau laser, où
la source de lumière (5) est montée fixe par rapport au détecteur optique (7), de sorte que la zone du substrat à semi-conducteurs pénétrée par le faisceau laser reste fixe pendant l'avance dans la zone balayée par le détecteur optique (7), et où le dispositif d'avance déplace le substrat à semi-conducteurs par rapport à l'ensemble composé de la source de lumière et du détecteur, et le système de calcul enregistre des signaux de détecteur successifs et les réunit pour obtenir une image de surface, où la source de lumière (5) est une source de lumière infrarouge (5) qui produit deux faisceaux laser (56, 57) coaxiaux se déplaçant en sens inverse, qui sont guidés à travers le substrat à semi-conducteurs (3), où la lumière dispersée des deux faisceaux laser (56, 57) est détectée de manière sélective avec un détecteur optique (7), et où respectivement une partie d'image (72, 73) de la surface est produite par les signaux de détecteur détectés sélectivement de la lumière dispersée de chacun des faisceaux laser (56, 57), et où les parties d'image (72, 73) sont réunies pour obtenir une image totale, où
- un dispositif de déclenchement (76) est prévu, qui synchronise de manière intermittente les deux faisceaux (56, 57), où
- le détecteur optique (7) est synchronisé avec la synchronisation des deux faisceaux (56, 57), de sorte que des signaux de détecteur de la lumière dispersée des premier et deuxième faisceaux lumineux (56, 57) sont produits par intermittence par le détecteur optique (7), où le dispositif de déclenchement (76) émet en outre des signaux de déclenchement, lesquels synchronisent le détecteur optique (7) avec la source de lumière infrarouge (5) et délivre d'autres impulsions de déclenchement au détecteur optique (7) pendant les intervalles entre les impulsions de déclenchement au moyen desquelles le détecteur optique (7) est synchronisé avec la source de lumière à infrarouge (5), de sorte que le détecteur optique (7) détecte dans chaque cas la lumière d'une autre source de lumière pendant les intervalles de temps durant lesquels la source de lumière infrarouge (5) est mise hors tension.

2. Procédé selon la revendication 1, **caractérisé en ce qu'**une lumière infrarouge d'une longueur d'onde d'au moins 1,2 micromètre est introduite dans la surface de bord (33).

3. Procédé selon l'une quelconque des revendications précédentes, **caractérisé en ce que**, à partir des données d'image obtenues par le détecteur optique (7) produisant une image, une fissure (34) est identifiée par une évaluation de la distribution de luminance locale.

4. Procédé selon l'une quelconque des revendications précédentes, **caractérisé en ce qu'**au moins une acquisition de l'électroluminescence et/ou une acquisition de la photoluminescence et/ou une acquisition du fond clair ou du fond noir sont en outre mises en œuvre.

5. Procédé selon l'une quelconque des revendications précédentes, dans lequel une fissure sous une structure opaque sur la face latérale du substrat à semi-conducteurs (3) tournée vers le détecteur (7) est repérée par éclairage du bord de la structure opaque.
